# EUROPEAN PATENT SPECIFICATION

(11) **EP 1 246 456 B1**
(45) Date of publication and mention of the grant of the patent: **29.09.2004**
(21) Application number: 02006376.4
(22) Date of filing: 21.03.2002
(51) Int. Cl.: H04N 5/225

(54) **Imaging device and manufacturing method thereof**
Bildaufnahmegerät und Verfahren zu dessen Herstellung
Dispositif d'imagerie et Procédé pour son fabrication

(30) Priority: 28.03.2001 JP 2001093815
(43) Date of publication of application: 02.10.2002
(73) Proprietor: MITSUBISHI DENKI KABUSHIKI KAISHA, Tokyo 100-8310 (JP)
(72) Inventor: Miyake, Hiroyuki, c/o Mitsubishi Denki K.K., Tokyo 100-8310 (JP); Komori, Noriyuki, c/o Mitsubishi Denki K.K., Tokyo 100-8310 (JP)
(74) Representative: Bohnenberger, Johannes, Dr.

(56) References cited:
- EP-A- 0 526 636
- EP-A- 0 950 912
- WO-A-99/11056
- DE-A- 19 802 816
- FR-A- 2 690 533
- US-A- 5 414 444

## Description

### Background of the Invention

### 1. Technical Field

The present invention relates to an imaging device for use in hand-held terminals such as cellular phones, PDA (photo-detector array), and electronic apparatus such as personal computers, video cameras, scanners, etc. The invention also relates to a manufacturing method of the imaging device.

The present patent application is relevant to the European Patent Application No. 0 2 006 375.6 filed on 21.03.2002 by the applicant (corresponding to the Japanese Patent Application No.2001-098799 filed on March 30, 2001).

### 2. Background Art

Imaging devices are widely used in hand-held terminals of cellular phones and the like under the background of recent progress of communication technology. These imaging devices are increasingly demanded to be more small-sized, and various technological developments have been attempted for small sizing.

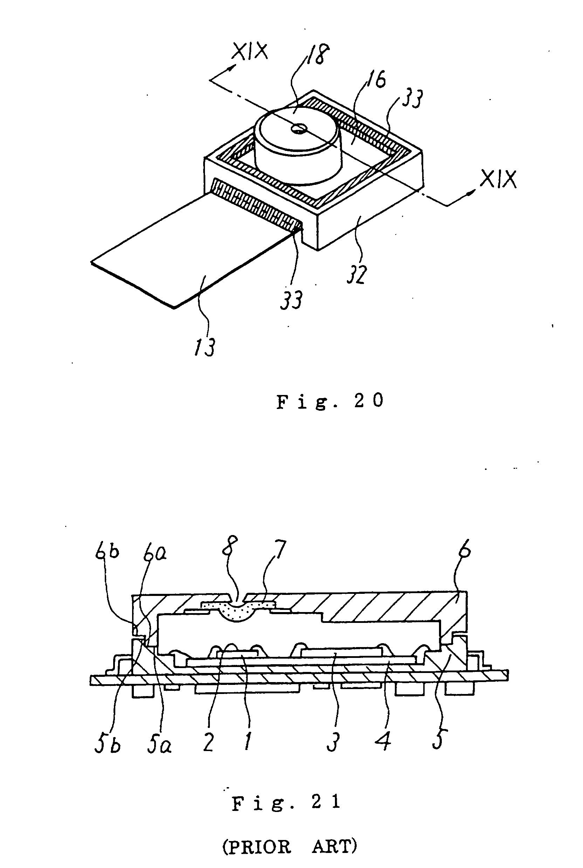

Fig. 21 is a sectional view showing an imaging device according to a prior art disclosed in the Japanese Patent Publication (unexamined) No. 112854/1999. Reference numeral 1 is an imaging element having a light acceptance plane 2 and numeral 3 is a peripheral circuit element. These elements are mounted on a circuit board 4. Numeral 5 is an accommodating vessel in which the circuit board 4 having the imaging element 1 and the peripheral circuit element 3 is accommodated. Numeral 6 is a lens holder for holding a lens 7. Numeral 8 is an optical diaphragm. Peripheral frame portion of the lens holder 6 is provided with a protrusion 6a on inside and a bottom portion 6b on outside, thereby a step being formed. Peripheral frame portion of the accommodating vessel 5 is provided with a bottom portion 5a on inside and a protrusion 5b on outside, thereby a step being formed.

The protrusion portion 6a inside of the lens holder 6 and the bottom portion 5a inside of the accommodating vessel 5 form an optical positioning reference plane for positioning optically. Accordingly, when the lens holder 6 and the accommodating vessel 5 are combined with each other, the protrusion 6a of the lens holder 6 serving as the optical positioning reference plane and the bottom portion 5a of the accommodating vessel 5 are brought into contact with each other. At this time, a clearance is formed between the bottom portion 6b of the lens holder 6 and the protrusion portion 5b of the accommodating vessel 5, and therefore the clearance is utilized for gluing them together. In this manner, an optical axis is prevented from deviation due to insufficient application of adhesive.

In the mentioned imaging device according to the prior art, however, a problem exists in that the distance between light acceptance plane 2 of the imaging element 1 and the lens 7 is positioned at a predetermined focal distance even if the deviation of optical axis is corrected. More specifically, dispersion just in the aspect of thickness of the imaging element 1 mounts to several 10 µm. There may be further dispersion in thickness of circuit board 4 and in thickness due to adherence between the imaging element 1 and circuit board 4 as well as between the circuit board 4 and the accommodating vessel 5. Considering the foregoing dispersion, a problem exists in that the distance between light acceptance plane 2 of the imaging element 1 and the lens 7 is accurately located a predetermined focal distance. This problem becomes more serious as the imaging device becomes more small-sized.

Another problem exists in that when mounting the imaging element 1 on the circuit board and the accommodating vessel of large thickness, length in the direction of height becomes larger.

EP 0 526 836 relates to a lens for a television camera which is provided with a lens part having a lens for a color camera, a transparent parallel plane body having parallel planes which is provided behind the lens part, and a ring-like plate mounted on a mount seat of the lens part.

DE 198 02 816 relates to an imaging element mounted on one side of a circuit board.

### Summary of the Invention

The present invention has been made to solve the above-discussed problems and has an object of providing an imaging device of high quality in which the distance between the light acceptance plane of the imaging element and the lens can be located at a predetermined focal distance. The invention also provides a manufacturing method of the imaging device.

Imaging devices and manufacturing methods according to the invention are set out in the claims.

As a result, the distance between the light acceptance plane of the imaging element and the image formation lens can be located at a predetermined focal distance with accuracy.

Further, assembling the imaging device becomes easy, and the distance between the light acceptance plane of the imaging element and the image formation lens can be located at a predetermined focal distance with accuracy.

Further, the focal distance of the image formation lens can be adjusted whenever required.

Further, even if a part of the adhesive is pressed out, the light acceptance plane and/or the circuit element are prevented from being damaged.

Further, the imaging element can be protected.

Further, the adhesive can be prevented from being pressed out, and an adhesive of low viscosity can be used when required.

Further, positioning the frame member and the supporting member becomes easy, and the distance between the light acceptance plane of the imaging element and the image formation lens can be located at a predetermined focal distance with accuracy.

Further, the adhesion and sealing can be performed preventing the adhesive from being pressed out.

Further, the light acceptance plane is prevented from being damaged.

Further, it becomes possible to adhere the imaging element plane on the side of light acceptance plane and the reference plane of the frame member together on the same plane.

### Brief Description of the Drawings

Fig. 1 shows an imaging device according to Embodiment 1 of the present invention, and is a sectional view taken along the line I- I in Fig. 2.
Fig. 2 is a perspective view of the imaging device according to Embodiment 1.
Fig. 3 is an exploded perspective view of a part of the imaging device showing a manufacturing method according to Embodiment 1.
Fig. 4 is an exploded perspective view showing the manufacturing method.
Fig. 5 is a sectional view showing the manufacturing method.
Fig. 6 is a sectional view showing the imaging device according to Embodiment 2 of the invention.
Fig. 7 is a sectional view of a part of the imaging device showing a manufacturing process according to Embodiment 3 of the invention.
Fig. 8 is a sectional view of a part of the imaging device showing a manufacturing process according to Embodiment 4 of the invention.
Fig. 9 is a sectional view of a part of the imaging device showing a manufacturing process according to Embodiment 5 of the invention.
Fig. 10 is a sectional view of a part of the imaging device showing a manufacturing process according to Embodiment 6 of the invention.
Fig. 11 is a sectional view of a part of the imaging device showing a manufacturing process according to Embodiment 6 of the invention.
Fig. 12 is a sectional view of a part of the imaging device showing a manufacturing process according to Embodiment 7 of the invention.
Fig. 13 is an exploded perspective view under the manufacturing process of the imaging device according to Embodiment 8 of the invention.
Fig. 14 is a perspective view of a completed imaging device according to Embodiment 8.
Fig. 15 is a sectional view of a part of the imaging device under the manufacturing process according to Embodiment 8.
Fig. 16 is a sectional view of a part of the imaging device under the manufacturing process according to Embodiment 9 of the invention.
Fig. 17 is a sectional view of a part of the imaging device under the manufacturing process according to Embodiment 10 of the invention.
Fig. 18 is an exploded perspective view of the imaging device under the manufacturing process according to Embodiment 10.
Fig. 19 is a sectional view of the imaging device according to Embodiment 10.
Fig. 20 is a perspective view of a completed imaging device according to Embodiment 10.
Fig. 21 is a sectional view of the imaging device according to the prior art.

### Description of the Preferred Embodiments

### Embodiment 1.

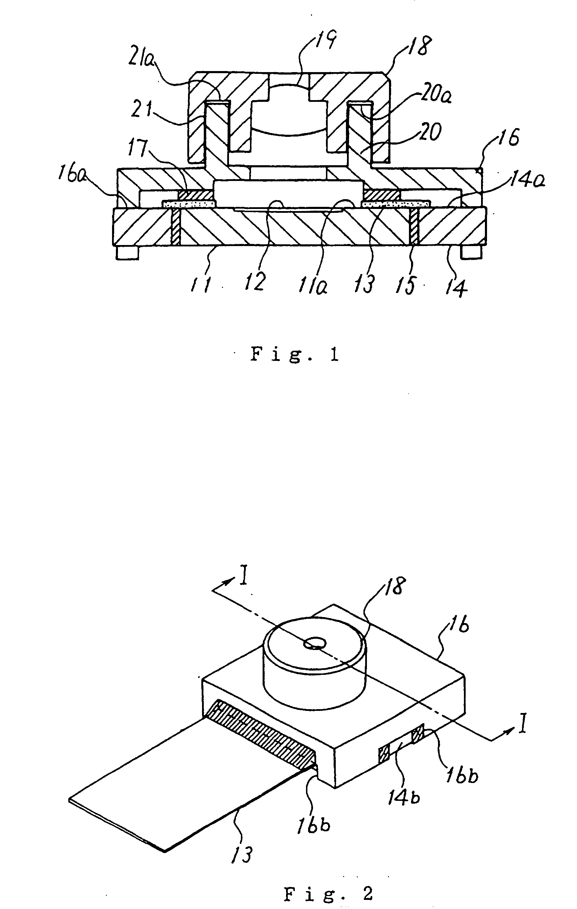

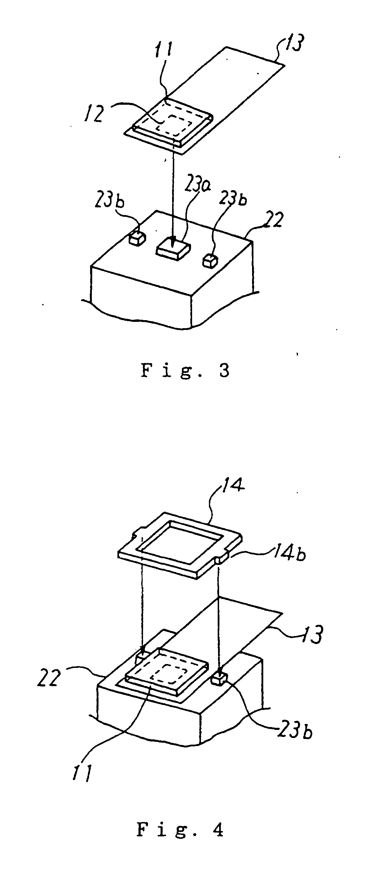

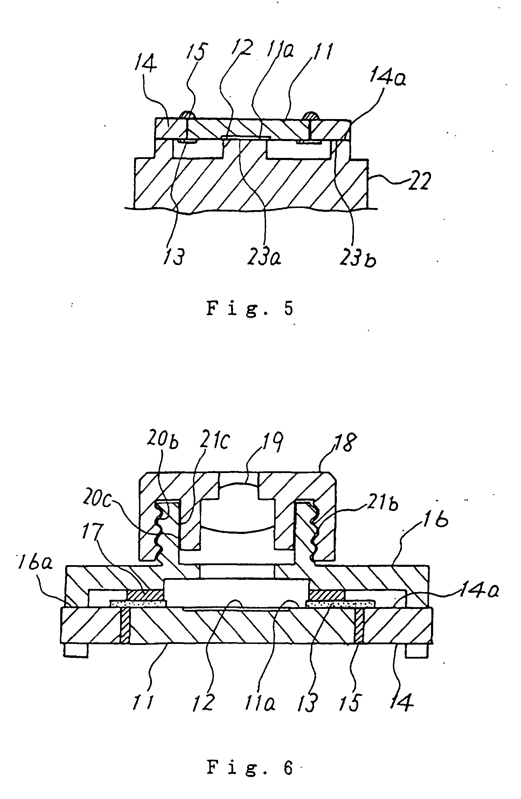

Fig. 1 showing an imaging device according to Embodiment 1 of the invention is a sectional view taken along the line I-I in Fig. 2. Fig. 2 is a perspective view of the imaging device according to Embodiment 1. Fig. 3 is an exploded perspective view showing a manufacturing method of the imaging device according to Embodiment 1. Fig. 4 is an exploded perspective view showing the manufacturing method, and Fig. 5 is a sectional view of the manufacturing method showing a manufacturing process subsequent to Fig. 4.

In the drawings, reference numeral 11 is an imaging element having a light acceptance plane 12 on the imaging element plane opposite to an image formation lens. Numeral 13 is a film-like circuit board to which the imaging element 11 is glued by connecting a terminal thereof to wiring of the circuit board. Peripheral circuit element comprised of semi-conductor chip, capacitor and register are packaged in the film-like circuit board 13, though not illustrated. Numeral 14 is a frame member surrounding the square imaging element 11 fixedly with an adhesive 15 in such a manner that a reference plane 14a of the frame member 14 and a reference plane 11a of the imaging element 11 on the light acceptance plane 12 may come on the same plane. Numeral 16 is a supporting member of which reference plane 16a and the reference plane 14a of the frame member 14 are brought into contact with each other, and the frame member 14 having the imaging element 11 and the supporting member 16 are integrated by applying an adhesive.

Numeral 18 is a cylindrical lens holder fixedly holding an image formation lens 19 on one end. The cylindrical lens holder 18 is supported on the supporting member 16 by fitting a cylindrical protrusion 20 of the supporting member 16 into a cylindrical recess 21. A reference plane 20a of a the cylindrical protrusion 20 of the supporting member 16 and a reference plane 21a of the cylindrical recess 21 of the lens holder 18 brought into contact with each other at the position of full-fitting. As a result, the image formation lens 19 can be located at a predetermined focal distance with respect to the light acceptance plane 12 of the imaging element 11. Thus, positioning in longitudinal direction can be achieved with high accuracy, and positioning in transverse direction (optical axis of the image formation lens) is regulated with high accuracy by fitting the cylindrical protrusion 20 of the supporting member 16 and the cylindrical recess 21 of the lens holder 18. In addition, the frame member 14, the supporting member 16 and the lens holder 18 are molded of plastic such as polycarbonate. Liquid photo-reactive adhesive, ultra-violet-setting adhesive and natural-setting instantaneous adhesive and the like can be used as the adhesive.

Figs. 3, 4 and 5 show the former stage of the manufacturing process of the imaging device in order. Numeral 22 is an assembling stage, on which three supporting protrusions 23a, 23b and 23b are provided. Upper end faces of the supporting protrusions 23a, 23b and 23b are flush serving as the reference plane. The reference plane 11a on the light acceptance plane 12 side in the imaging element 11 glued to the circuit board 13 is positioned on the reference plane of the supporting protrusion 23a and brought into contact with the reference plane (Fig. 4). Subsequently, the frame member 14 is positioned so as to surround the imaging element 11, and the reference plane 14a of the frame member 14 is brought into contact with the reference plane of the supporting protrusion 23b. In addition, numeral 14b is a projection of the frame member.

Referring to Fig. 5, the reference plane 11a of the imaging element 11 and the reference plane of the supporting protrusion 23a, and the reference plane 14a of the frame member 14 and the reference plane of the supporting protrusion 23b are respectively brought into contact with each other. Then applying a load from above in the drawing holds those reference planes. Subsequently, an adhesive 15 is applied from the opposite side of the light acceptance plane of the imaging element 11, whereby the imaging element 11 and the frame member are fixedly glued to each other and integrated. At this time, a tensile force is applied as the setting of the adhesive. Therefore, by applying a load larger than the tensile force, the reference plane 11a of the imaging element 11 and the reference plane 14a of the frame member 14 are caused to keep the same plane, thus the adhesion step being completed.

The frame member 14 having the imaging element 1 integrated therewith is turned upside down, and as shown in Fig. 1, the reference plane 14a of the frame member 14 and the reference plane 16a of the supporting member 16 are brought into contact with each other and positioned. Holding such a positioned state, those reference planes are integrated by applying the adhesive 17. The adhesive 17 is further applied to a portion between the projection 14a of the frame member 14 and the recess 16a of the supporting member, and a portion between the circuit board 13 and the recess 16a of the supporting member 16 for fixing them. The remaining process is as described with reference to Fig. 1.

In the imaging device of above construction, the contact is established between the reference planes 11a and 14a as well as between the reference planes 14a and 16a on the same plane. The contact is also established between the reference planes 20a and 21a, and therefore the image formation lens 19 is positioned at a predetermined focal distance with high accuracy with respect to the light acceptance plane 12, thereby positioning accuracy in longitudinal direction being improved. Further, the imaging device according to Embodiment 1 can be formed compact in longitudinal direction. More specifically, it is certain that there is an overlap in longitudinal direction between the film-like circuit board 13 and the imaging element 11. But since the circuit boar is film-like, the overlap is very little, and the frame member 14 substantially supports the imaging element 11. Thus, there is no overlap in longitudinal direction between the imaging element 11 and the frame member 14. Furthermore, since the imaging element 11 and the frame member 14 are glued to each other on the opposite side of the light acceptance plane, the adhesive 15 is not pressed out, and there is no sticking of the adhesive 15 to the light acceptance plane.

### Embodiment 2.

Fig. 6 is a sectional view showing an imaging device according to Embodiment 2 of the invention. In the drawing, numeral 20b is a threaded (male screw) portion of the cylindrical protrusion 20, and numeral 21b is a threaded (female screw) portion of the cylindrical recess 21. By providing such threaded portions 20b, 21b and screw-engaging them, it becomes possible to further delicately adjust the predetermined focal distance of the image formation lens 19 with respect to the light acceptance plane 2. In addition, the positioning in transverse direction (optical axis of the image formation lens) is regulated with high accuracy by a fitting contact face 20c of the supporting member 16 and a fitting contact face 21c of the lens holder 18.

### Embodiment 3.

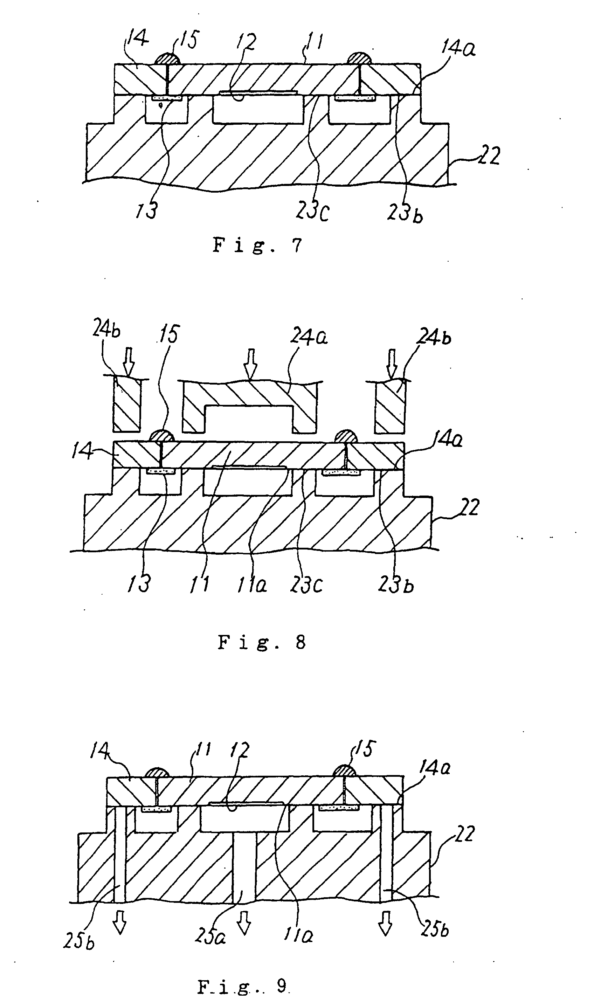

Fig. 7 is a sectional view of a part of the imaging device showing a manufacturing process according to Embodiment 3 of the invention. The supporting protrusion 23a shown in Fig. 5 according to the foregoing Embodiment 1 of the invention is directly in contact with the light acceptance plane 12 of the imaging element 11. On the other hand, a supporting protrusion 23c in Fig. 7 is in contact with the face of the imaging element 11 getting out the light acceptance plane 12. As a result, the light acceptance plane 12 can be prevented from being damaged due to direct contact of the supporting protrusion with the light acceptance plane 12.

### Embodiment 4.

Fig. 8 is a sectional view of a part of the imaging device showing a manufacturing process according to Embodiment 4 of the invention, and in which a load is applied to the imaging element 11 and the frame member 14 at the time of gluing them to each other. In the drawing, numerals 24a, 24b are pressing tools that are configured to be suited for applying a load to the position opposite to the supporting protrusions 23c, 23b. By applying a load using the pressing tools 24a, 24b, the reference plane 11a of the imaging element 11 and the reference plane 14a of the frame member 14 are forced to keep the same plane, and then the adhesion is completely performed.

### Embodiment 5.

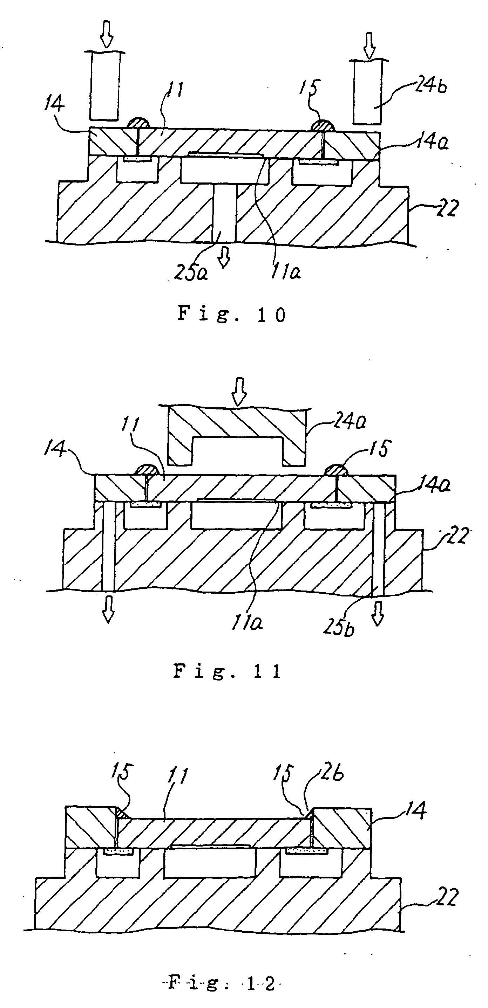

Fig. 9 is a sectional view of a part of the imaging device showing a manufacturing process according to Embodiment 5 of the invention, and in which the imaging element 11 and the frame member 14 are held by vacuum suction at the time of gluing them together. In the drawing, numerals 25a, 25b are suction ports provided through the stage 22. The suction port 25a sucks the imaging element 11, and the suction port 25b sucks the frame member 14. With the vacuum suction by the suction ports 25a, 25b, the reference plane 11a of the imaging element 11 and the reference plane 14a of the frame member 14 are forced to keep the same plane, and then the adhesion is completely performed.

### Embodiment 6.

Figs. 10 and 11 are sectional views of a part of the imaging device respectively showing a manufacturing process according to Embodiment 6 of the invention. In this embodiment, the imaging element 11 and the frame member 14 are held by vacuum suction while applying a load thereto at the time of gluing them together. The reference plane 11a of the imaging element 11 and the reference plane 14a of the frame member 14 are forced to keep the same plane by the application of load and by vacuum suction. As a result, the delicate imaging element is stabled all the more, and then the adhesion is completely performed.

### Embodiment 7.

Fig. 12 is a sectional view showing an imaging device according to Embodiment 7 of the invention. In this embodiment, the frame member 14 is made larger than the imaging element 11 in thickness, a level difference is provided at the contact position between them, and the adhesive is applied to the corner 26 formed by such level difference to adhere them together. In this manner, it is possible to prevent unnecessary dispersion of the adhesive, and furthermore any adhesive of low viscosity can be used.

### Embodiment 8.

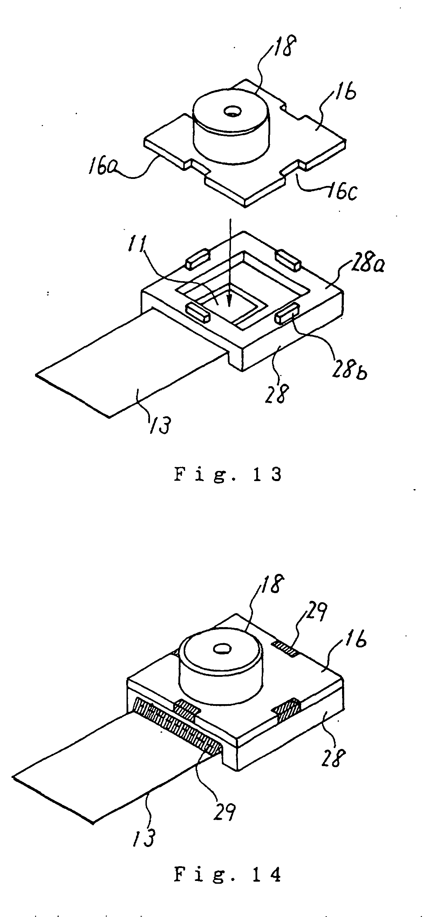

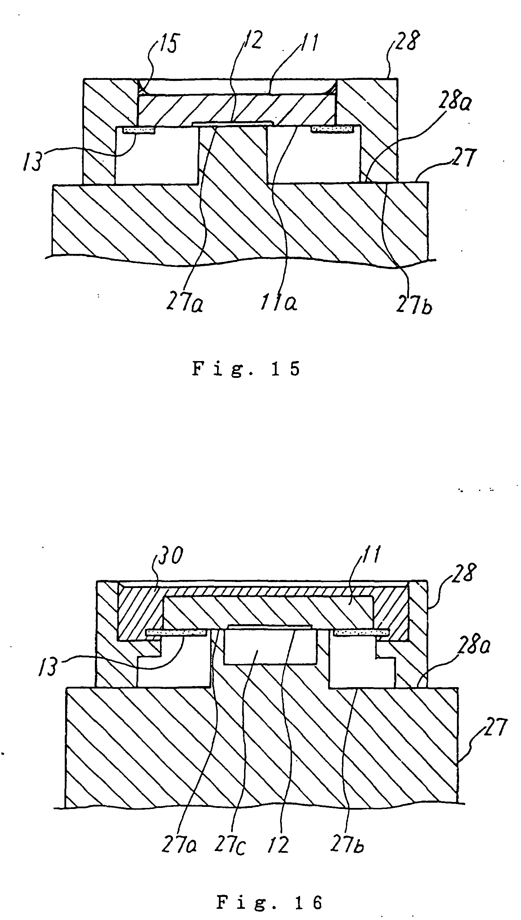

Fig. 13 is an exploded perspective view under the manufacturing process of the imaging device according to Embodiment 8 of the invention, Fig. 14 is a perspective view of a completed imaging device according to Embodiment 8, and Fig. 15 is a sectional view of a part of the imaging device under the manufacturing process according to Embodiment 8.

In Fig. 15, numeral 27 is an assembling stage having a first reference plane 27a and a second reference plane 27b with a level difference therebetween. The reference plane 11a of the imaging element 11 on the side of the light acceptance plane 2 is brought into contact with the first reference plane 27a and placed thereon. Numeral 28 is a square frame member that is positioned so as to surround the imaging element 11, and a reference plane 28a of the square frame member 28 is brought into contact with the second reference plane 27b of the stage 27 and held there. As a result, the plane 11a of the imaging element 11 on the side of the mentioned light acceptance plane 12 and the reference plane 28a of the frame member 28 can be held to have a predetermined difference in relative distance. Keeping the contact state, a load is applied to the imaging element 11 and the frame member 28 for holding, whereby the imaging element 11 and the frame member 28 are fixedly glued to each other and integrated.

As shown in Fig. 13, the imaging element 11 and the frame member 28 integrated in one unit is provided with projections 28b for regulation of positioning at the four corners of the reference plane 28a respectively. Numeral 16 is a supporting member for supporting the lens holder 18 having an image formation lens thereon, and of which lower part is a flat plate and bottom face serves as a reference plane 16a. The flat plate on the lower part has recesses (cutout parts) 16c respectively at the four corners. Referring to Fig. 13, the supporting member 16 is moved in the direction indicated by the arrow, and the projections 28b of the frame member 28 are fitted to the recesses 16c of the supporting member 16 for positioning. At the same time, the reference plane 28a of the frame member 28 and the reference plane 16a of the supporting member 16 are brought into contact with each other to be held. Holding such a contact state while applying a load, the frame member 28 and the supporting member 16 are glued and integrated in one unit.

Fig. 14 shows an assembled imaging device, and in which numeral 29 are the glued portions. In the imaging device of above construction, the reference plane 11a of the imaging element 11 on the side of the light acceptance plane 12 and the reference plane 28a of the frame member 28 are fixedly supported with a predetermined difference in relative distance. Such fixation and support are achieved by the direct contact between the reference planes 28a, 16a and, as a result, the image formation lens 19 can be located at a predetermined focal distance with respect to the light acceptance plane with high accuracy.

### Embodiment 9.

Fig. 16 is a sectional view of a part of the imaging device under the manufacturing process according to Embodiment 9 of the invention, and shows a modification of the construction shown in Fig. 15. Difference from Fig. 15 is hereinafter described. The first reference plane 27a of the assembling stage 27 is provided with a recess 27c at the central portion. Thus, the imaging element 11 does not come in contact with the light acceptance plane 12 when mounted, and the light acceptance plane 12 is prevented from being damaged. Numeral 30 is an adhesive for integrally gluing the imaging element 11 and the frame member 28, and the glued portion is sealed with the adhesive. It is also preferable that the construction shown in Fig. 16 is employed, instead of that shown in Fig. 15, to form the construction shown in Figs. 13 and 14.

### Embodiment 10.

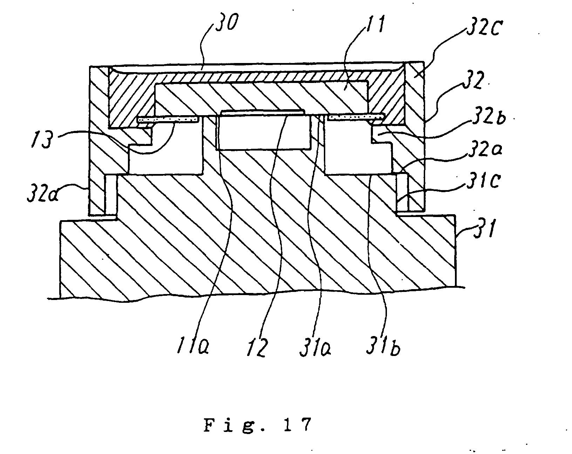

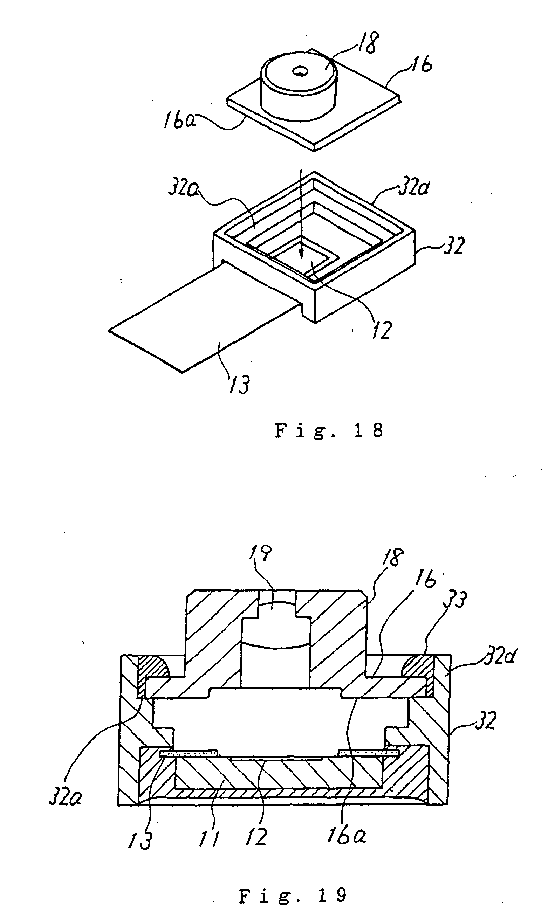

Fig. 17 is a sectional view of a part of the imaging device under the manufacturing process according to Embodiment 10 of the invention, and Fig. 18 is an exploded perspective view of the imaging device under the manufacturing process according to Embodiment 10. Fig. 19 shows the imaging device according to Embodiment 10 and is a sectional view taken along the line X I X-X I X, and Fig. 20 is a perspective view of the imaging device according to Embodiment 10. In Fig. 17, numeral 17 is an assembling stage having a first reference plane 31a and a second reference plane 31b with a level difference therebetween, and is provided with an annular notch 31c. Numeral 32 is a square frame member provided with plural level differences inside, and a reference plane 32a is brought into contact with the second reference plane 31b for positioning and placed thereon. Numeral 32d is a wall portion of the frame member 32. The reference plane 11a of the imaging element 11 on the side of the light acceptance plane 12 is brought into contact with the first reference plane 31a for positioning and placed thereon. As a result, the level difference portion 32b and the peripheral wall 32c of the frame member 32 surround the imaging element 11.

Keeping such a state, a load is applied to the imaging element 11 and the frame member 32, and they are glued and sealed with the adhesive 30. As a result, the reference plane 11a of the imaging element 11 on the side of the light acceptance plane 12 and the reference plane 32a of the frame member 32 are glued and sealed with a predetermined difference in relative distance. Thus, the imaging element 11 and the frame member 32 are integrated.

When the frame member 32 having the imaging element 11 integrated therewith is taken out of the stage and turned upside down, a component as shown in the lower part of Fig. 18 is obtained. The wall portion 32d surrounds the reference plane 32a of the frame member 32, and the reference plane 32a and the wall portion 32d form a cavity. Numeral 16 is a supporting member for supporting the lens holder 18 having an image formation lens thereon, and of which lower part is a flat plate and bottom face serves as a reference plane 16a. Referring to Fig. 18, the supporting member 16 is moved in the direction indicated by the arrow, and are fitted in the cavity 16c of the frame member 32 for positioning. At the same time, the reference plane 32a of the frame member 32 and the reference plane 16a of the supporting member 16 are brought into contact with each other and held while applying a load. As shown in Fig. 19, height of the wall portion 32d is formed larger than thickness of the flat plate of the supporting member 16, and therefore a level difference is formed between the flat plate of the supporting member 16 and the wall portion 32d. By applying an adhesive 33 to the square level difference portion, the frame member 32 and the supporting member 16 are glued and integrated in one unit. Fig. 20 shows an integrally assembled imaging device.
In this Embodiment 10, the imaging element 11 and the frame member 32 are integrated such that the reference plane 11a of the imaging element 11 on the side of the light acceptance plane 12 and the reference plane 32a of the frame member 32 keeps a predetermined difference in relative distance. By employing the lens holder 18 and the supporting member 16 preliminarily combined with each other, number of components can be reduced. Furthermore, in this Embodiment 10, the image formation lens 19 is positioned at a predetermined focal distance with respect to the light acceptance plane 12.

## Claims

1. An imaging device comprising:
- an imaging element (11) having a light acceptance plane (12) and a thickness;
- a frame member (14, 32) for supporting the imaging element (11); and
- a supporting member (16) for supporting an image formation lens (19) having a reference plane (16a), wherein
said light acceptance plane (12) and said reference plane (14a, 32a) of said frame member (14, 32) are fixed with an adhesive so as to be located on the same plane or in a parallel plane having a predetermined difference in distance independently of said thickness, wherein
a reference plane (14a, 32a) of said frame member (14, 32) and the reference plane (16a) of said supporting member (16) for supporting the image formation lens (19) are in contact with each other and are integrated with an adhesive.

2. The imaging device according to claim 1, **characterized in that** the supporting member (16) for supporting the image formation lens (19) comprises a lens holder (18) for fixedly supporting said image formation lens (19) and a supporter (16) for supporting said lens holder (18), and said lens holder (18) is positioned and held on said supporter (16).

3. The imaging device according to claim 1, **characterized in that** the supporting member (16) for supporting the image formation lens (19) comprises a lens holder (18) for fixedly supporting said image formation lens (19) and a supporter (16) for fitting said lens holder (18), and said lens holder (18) is fitted to said supporter (16) so that said image formation lens (19) is located at a predetermined focal distance with respect to the light acceptance plane (12) of the imaging element (11) at a position of full fitting.

4. The imaging device according to claim 1, **characterized in that** the supporting member (16) for supporting the image formation lens (19) comprises a lens holder (18) for fixedly supporting said image formation lens (19) and a supporter (16) for screw-engaging with said lens holder (18) at a screw-threaded portion, and by adjusting said screw-threaded portion, a focus of said image formation lens (19) can be adjusted with respect to the light acceptance plane (12) of the imaging element (11).

5. The imaging device according to any of the preceding claims, in particular claim 1, **characterized in that** said frame member (14) surrounds said imaging element (11).

6. The imaging device according to claim 1, **characterized in that** a wall portion (32d) is provided round the reference plane (32a) of the frame member (32) to form a cavity, and the reference plane (32a) of said frame member (32) and the reference plane (16a) of said supporting member (16) for supporting the image formation lens (19) are in contact with each other within said cavity and sealed at a level difference portion between said wall portion (32d) and said supporting member (16).

7. A manufacturing method of an imaging device according to any of the preceding claims comprising:
in a 1st step, integrating an imaging element (11) and a frame member (14, 32) with an adhesive (15, 30),
in a 2nd step, integrating said frame member (14, 32) and a supporting member (16) for supporting an image formation lens (19) using an adhesive (17, 33) under the conditions of keeping a contact between the reference plane (14a, 32a) of said frame member (14, 32) and the reference plane (16a) of said supporting member (16), and said 1st step comprising the steps of
- arranging a light acceptance ' plane (12) of said imaging element (11) on a first reference plane (23a, 31a) of a stage (22, 31) in contact with said first reference plane (23a, 31a),
- arranging a reference plane (14a, 32a) of said frame member (14, 32) surrounding said imaging element (11) on a second reference plane (23b, 31b) of said stage (22, 32) in contact with said second reference plane (23b, 31b),
- holding said light acceptance plane (12) and the reference plane (14a, 32a) of said frame member (14, 32) on the same plane or a plane in a parallel plane having a predetermined difference in relative distance therebetween.

8. The manufacturing method of an imaging device according to claim 7,
**characterized in that**, on the reference plane of the stage (22), a portion of the imaging element (11) facing the light acceptance plane (12) is formed into a recess in such a manner that said light acceptance plane (12) and the reference plane of said stage (22) are not in contact with each other.

## Patentansprüche

1. Abbildungsvorrichtung, die folgendes aufweist:
- ein Abbildungselement (11), das eine Lichtaufnahmeebene (12) und eine Dicke hat;
- ein Rahmenelement (14, 32) zum Haltern des Abbildungselements (11); und
- ein Abstützelement (16), das ein Abbildungsobjektiv (19) abstützt und eine Bezugsebene (16a) hat, wobei
die Lichtaufnahmeebene (12) und die Bezugsebene (14a, 32a) des Rahmenelements (14, 32) mit einem Klebstoff so befestigt sind, daß sie auf derselben Ebene oder in einer parallelen Ebene angeordnet sind, die unabhängig von der genannten Dicke eine vorbestimmte Distanzdifferenz hat, wobei
eine Bezugsebene (14a, 32a) des Rahmenelements (14, 32) und die Bezugsebene (16a) des Abstützelements (16) zum Abstützen des Abbildungsobjektivs (19) miteinander in Kontakt und mit einem Klebstoff integriert sind.

2. Abbildungsvorrichtung nach Anspruch 1, **dadurch gekennzeichnet, daß** das Abstützelement (16) zum Abstützen des Abbildungsobjektivs (19) einen Objektivträger (18) zum festen Abstützen des Abbildungsobjektivs (19) und eine Abstützung (16) zum Abstützen des Objektivträgers (18) aufweist, und der Objektivträger (18) auf der Abstützung (16) positioniert und gehalten ist.

3. Abbildungsvorrichtung nach Anspruch 1, **dadurch gekennzeichnet, daß** das Abstützelement (16) zum Abstützen des Abbildungsobjektivs (19) einen Objektivträger (18) zum festen Abstützen des Abbildungsobjektivs (19) und eine Abstützung (16) zum Anbringen des Objektivträgers (18) aufweist, und der Objektivträger (18) an der Abstützung (16) so angebracht ist, daß in einer vollständigen Anbringposition das Abbildungsobjektiv (19) in einer vorbestimmten Brennweite in bezug auf die Lichtaufnahmeebene (12) des Abbildungselements (11) liegt.

4. Abbildungsvorrichtung nach Anspruch 1, **dadurch gekennzeichnet, daß** das Abstützelement (16) zum Abstützen des Abbildungsobjektivs (19) einen Objektivträger (18) zum festen Abstützen des Abbildungsobjektivs (19) und eine Abstützung (16) zum Gewindeeingriff mit dem Objektivträger (19) an einem Schraubgewindebereich aufweist, und durch Einstellen des Schraubgewindebereichs ein Brennpunkt des Abbildungsobjektivs (19) in bezug auf die Lichtaufnahmeebene (12) des Abbildungselements (11) eingestellt werden kann.

5. Abbildungsvorrichtung nach einem der vorhergehenden Ansprüche, insbesondere nach Anspruch 1, **dadurch gekennzeichnet, daß** das Rahmenelement (14) das Abbildungselement (11) umgibt.

6. Abbildungsvorrichtung nach Anspruch 1, **dadurch gekennzeichnet, daß** ein Wandbereich (32d) um die Bezugsebene (32a) des Rahmenelements (32) herum vorgesehen ist, um einen Hohlraum zu bilden, und die Bezugsebene (32a) des Rahmenelements (32) und die Bezugsebene (16a) des Abstützelements (16) zum Abstützen des Abbildungsobjektivs (19) miteinander innerhalb des Hohlraums in Kontakt sind und an einem Höhendifferenzbereich zwischen dem Wandbereich (32d) und dem Abstützelement (16) abgedichtet sind.

7. Verfahren zum Herstellen einer Abbildungsvorrichtung nach einem der vorhergehenden Ansprüche, das folgendes aufweist:
in einem ersten Schritt
- Integrieren eines Abbildungselements (11) und eines Rahmenelements (14, 32) mit einem Klebstoff (15, 30), in einem zweiten Schritt
- Integrieren des Rahmenelements (14, 32) und eines Abstützelements (16) zum Abstützen eines Abbildungsobjektivs (19) unter Verwendung eines Klebstoffs (17, 33) unter Bedingungen, unter denen ein Kontakt zwischen der Bezugsebene (14a, 32a) des Rahmenelements (14, 32) und der Bezugsebene (16a) des Abstützelements (16) aufrechterhalten wird, und der erste Schritt die folgenden Schritte aufweist:
- Anordnen einer Lichtaufnahmeebene (12) des Abbildungselements (11) auf einer ersten Bezugsebene (23a, 31a) eines Trägers (22, 31) in Kontakt mit der ersten Bezugsebene (23a, 31a),
- Anordnen einer Bezugsebene (14a, 32a) des Rahmenelements (14, 32), welches das Abbildungselement (11) auf einer zweiten Bezugsebene (23b, 31b) des Trägers (22, 32) umgibt, in Kontakt mit der zweiten Bezugsebene (23b, 31b),
- Halten der Lichtaufnahmeebene (12) und der Bezugsebene (14a, 32a) des Rahmenelements (14, 32) auf derselben Ebene oder einer Ebene in einer parallelen Ebene, die eine vorbestimmte Differenz hinsichtlich der relativen Distanz dazwischen hat.

8. Verfahren zum Herstellen einer Abbildungsvorrichtung nach Anspruch 7, **dadurch gekennzeichnet, daß** auf der Bezugsebene des Trägers (22) ein Bereich des Abbildungselements (11), welcher der Lichtaufnahmeebene (12) zugewandt ist, in einer Ausnehmung auf eine solche Weise gebildet wird, daß die Lichtaufnahmeebene (12) und die Bezugsebene (22) des Trägers nicht miteinander in Kontakt sind.

## Revendications

1. Dispositif d'imagerie comprenant :
- un élément d'imagerie (11) ayant un plan de réception de la lumière (12) et une épaisseur ;
- un élément de cadre (14, 32) soutenant l'élément d'imagerie (11) ; et
- un élément de support (16) soutenant une lentille de formation d'image (19) et ayant un plan de référence (16a),
dans lequel
ledit plan de réception de la lumière (12) et un plan de référence (14a, 32a) dudit élément de cadre (14, 32) sont fixés à l'aide d'un adhésif de manière à se situer sur le même plan ou dans un plan parallèle ayant une différence de distance prédéterminée indépendamment de ladite épaisseur, où
un plan de référence (14a, 32a) dudit élément de cadre (14, 32) et un plan de référence (16a) dudit élément de support (16) soutenant la lentille de formation d'image (19) sont mis en contact l'un avec l'autre et sont rendus solidaires à l'aide d'un adhésif.

2. Dispositif d'imagerie selon la revendication 1, **caractérisé en ce que** l'élément de support (16) soutenant la lentille de formation d'image (19) comprend un porte-lentille (18) servant de support fixe à ladite lentille de formation d'image (19) et un appui (16) soutenant ledit porte-lentille (18), et ledit porte-lentille (18) est disposé et maintenu sur ledit appui (16).

3. Dispositif d'imagerie selon la revendication 1, **caractérisé en ce que** l'élément de support (16) soutenant la lentille de formation d'image (19) comprend un porte-lentille (18) servant de support fixe à ladite lentille de formation d'image (19) et un appui (16) servant à assujettir ledit porte-lentille (18), et ledit porte-lentille (18) est assujetti audit appui (16) de telle manière que ladite lentille de formation d'image (19) est située à une distance focale prédéterminée relativement au plan de réception de la lumière (12) de l'élément d'imagerie (11) à une position d'assujettissement total.

4. Dispositif d'imagerie selon la revendication 1, **caractérisé en ce que** l'élément de support (16) soutenant la lentille de formation d'image (19) comprend un porte-lentille (18) servant de support fixe à ladite lentille de formation d'image (19) et un appui (16) servant à s'accoupler par vissage avec ledit porte-lentille (18) au niveau d'une partie filetée, et **en ce que** l'ajustement de ladite partie filetée permet d'ajuster la netteté de ladite lentille de formation d'image (19) par rapport au plan de réception de la lumière (12) de l'élément d'imagerie (11).

5. Dispositif d'imagerie selon l'une quelconque des revendications précédentes, notamment la revendication 1, **caractérisé en ce que** ledit élément de cadre (14) encadre ledit élément d'imagerie (11).

6. Dispositif d'imagerie selon la revendication 1, **caractérisé en ce qu'**une partie de paroi (32d) est prévue sur le pourtour du plan de référence (32a) de l'élément de cadre (32) pour former une cavité, et **en ce que** le plan de référence (32a) dudit élément de cadre (32) et le plan de référence (16a) dudit élément de support (16) soutenant la lentille de formation d'image (19) sont en contact l'un avec l'autre à l'intérieur de ladite cavité et présentent une étanchéification à une partie où existe une différence de niveau entre ladite partie de paroi (32d) et ledit élément de support (16).

7. Procédé de fabrication d'un dispositif d'imagerie selon l'une quelconque des revendications précédentes, comprenant :
une première étape consistant à solidariser un élément d'imagerie (11) et un élément de cadre (14, 32) à l'aide d'un adhésif (15, 30),
une seconde étape consistant à solidariser ledit élément de cadre (14, 32) et un élément de support (16) soutenant une lentille de formation d'image (19) à l'aide d'un adhésif (17, 33) dans les conditions où l'on maintient le contact entre le plan de référence (14a, 32a) dudit élément de cadre (14, 32) et le plan de référence (16a) dudit élément de support (16), ladite première étape comprenant les étapes consistant à
- disposer un plan de réception de la lumière (12) dudit élément d'imagerie (11) sur un premier plan de référence (23a, 31a) d'une platine (22, 31) en le mettant en contact avec ledit premier plan de référence (23a, 31a),
- disposer un plan de référence (14a, 32a) dudit élément de cadre (14, 32) encadrant ledit élément d'imagerie (11) sur un second plan de référence (23b, 31b) de ladite platine (22, 32) en le mettant en contact avec ledit second plan de référence (23b, 31b),
- maintenir ledit plan de réception de la lumière (12) et le plan de référence (14a, 32a) dudit élément de cadre (14, 32) sur le même plan ou sur un plan situé dans un plan parallèle ayant une différence de distance prédéterminée entre ceux-ci.

8. Procédé de fabrication d'un dispositif d'imagerie selon la revendication 7, **caractérisé en ce que**, sur le plan de référence de la platine (22), une partie de l'élément d'imagerie (11) faisant face au plan de réception de la lumière (12) présente un creux de sorte à ce que ledit plan de réception de la lumière (12) et le plan de référence de ladite platine (22) ne soient pas en contact l'un avec l'autre.
